# EUROPEAN PATENT APPLICATION

(11) **EP 4 506 929 A1**
(43) Date of publication of application: **12.02.2025**
(21) Application number: 23784533.4
(22) Date of filing: 14.02.2023
(51) Int. Cl.: G09F 9/33, G09F 9/30, H01L 33/50, H01L 33/54, H01L 33/58

(54) **DISPLAY DEVICE**

(30) Priority: 07.04.2022 JP 2022063848
(71) Applicant: Toppan Holdings Inc., Tokyo 110-0016 (JP)
(72) Inventor: YAMAUCHI, Atsushi, Tokyo 110-0016 (JP); MICHI, Hiroyuki, Tokyo 110-0016 (JP); OKAMURA, Mitsuhiro, Tokyo 110-0016 (JP); MATSUYAMA, Saori, Tokyo 110-0016 (JP); HAFURI, Miho, Tokyo 110-0016 (JP)
(74) Representative: Hoffmann Eitle
(86) International application number: PCT/JP2023/005031
(87) International publication number: WO 2023/195239

(57) **Abstract**

To provide a display device capable of displaying a bright image by a light-emitting diode. A display device (1A) includes: a substrate (2); a barrier layer (3); a plurality of light-emitting diodes (4); and a plurality of lenses (5). The barrier layer (3) is provided on the substrate (2). The barrier layer (3) has a plurality of through holes. The plurality of light-emitting diodes (4) is disposed in the plurality of respective through holes. The plurality of lenses (5) is disposed at positions of the plurality of respective through holes. The lenses (5) each have a first surface (5a) and a second surface (5b), the second surface (5b) is a convex surface, and height (H5T) of a top of the convex surface based on the substrate (2) is greater than height (H3) of an upper surface of the barrier layer (3) based on the substrate (2). The first surface (5a) is opposed to the substrate (2) with the light-emitting diode (4) therebetween. The second surface (5b) is a back of the first surface (5a).

## Description

### Technical Field

The present invention relates to a display device.

### Background Art

Head mounted displays such as AR glasses and MR glasses can be used to experience virtual reality (VR), augmented reality (AR), or mixed reality (MR). Display devices mounted on the head mounted displays are required to be low-power, small, and lightweight display devices capable of displaying high-luminance and high-definition images.

As small display devices mountable on head mounted displays, a variety of display devices have been under development such as LCOS (Liquid Crystal on Silicon) microdisplays, LBS (Laser Beam Scanning) displays, and OLED-on-Silicon microdisplays. None of these, however, satisfy the requirements described above sufficiently.

MicroLED (Light-Emitting Diode) displays are considered the most promising display devices that can satisfy the requirements described above. This has been advancing intensive research and development about microLED displays.

A small microLED display mountable on a head mounted display sometimes has a microlens disposed in front of a light-emitting diode (PTLs 1 and 2). Light emitted by the light-emitting diode is diffused light. The microlens brings the diffused light emitted by the light-emitting diode closer to being collimated light.

### Citation List

### Patent Literature

PTL 1: CN 201911308310 A
PTL 2: EP 15801484 A

### Summary of the Invention

An object of the present invention is to provide a display device capable of displaying a bright image by a light-emitting diode.

According to an aspect of the present invention, there is provided a display device including: a substrate; a barrier layer; a plurality of light-emitting diodes; and a plurality of lenses. The barrier layer is provided on the substrate. The barrier layer has a plurality of through holes. The plurality of light-emitting diodes is disposed in the plurality of respective through holes. The plurality of lenses is disposed at positions of the plurality of respective through holes. The lenses each have a first surface and a second surface, the second surface is a convex surface, and a height of a top of the convex surface based on the substrate is greater than the height of an upper surface of the barrier layer based on the substrate. The first surface is opposed to the substrate with the light-emitting diode therebetween. The second surface is a back of the first surface.

According to another aspect of the present invention, the display device according to the aspect is provided in which height of a peripheral portion of the convex surface based on the substrate is less than or equal to the height of the upper surface of the barrier layer based on the substrate.

According to still another aspect of the present invention, the display device according to any of the aspects is provided that further includes one or more layers which are positioned in each of the plurality of through holes and interposed between the lens and the light-emitting diode.

According to still another aspect of the present invention, the display device according to the aspect is provided in which a refractive index of a layer adjacent to the lens among the one or more layers is lower than a refractive index of the lens.

According to still another aspect of the present invention, the display device according to any of the aspects is provided in which the barrier layer includes a light transmissive portion in contact with at least one of the one or more layers and a refractive index of the layer in contact with the light transmissive portion among the one or more layers is higher than a refractive index of the light transmissive portion.

According to still another aspect of the present invention, the display device according to any of the aspects is provided in which the barrier layer has a multilayer structure.

According to still another aspect of the present invention, the display device according to the aspect is provided in which the barrier layer includes a first layer and a second layer that is provided on the first layer. The first layer has a light shielding property. The second layer includes a light transmissive resin.

According to still another aspect of the present invention, the display device according to the aspect is provided in which the barrier layer further includes a third layer that is provided on the second layer. The third layer has a light shielding property.

According to still another aspect of the present invention, the display device according to any of the aspects is provided that further includes a plurality of filler layers with which the plurality of respective through holes is filled. The plurality of filler layers is each interposed between one of the plurality of lenses and the substrate. The plurality of filler layers each has the light-emitting diode opposed to that lens buried in the filler layer.

According to still another aspect of the present invention, the display device according to the aspect is provided in which at least a portion of the plurality of filler layers includes a wavelength conversion layer.

According to still another aspect of the present invention, the display device according to the aspect is provided in which a filler layer that includes the wavelength conversion layer among the plurality of filler layers further includes a colored layer that is interposed between the wavelength conversion layer and the lens.

According to still another aspect of the invention, the display device according to any of the aspects is provided in which at least a portion of the plurality of filler layers includes a transparent resin layer.

According to the present invention, there is provided a display device capable of displaying a bright image by a light-emitting diode.

### Brief Description of the Drawings

[Fig. 1] Fig. 1 is a cross-sectional view of a display device according to a first embodiment of the present invention.
[Fig. 2] Fig. 2 is a cross-sectional view of a display device according to a second embodiment of the present invention.
[Fig. 3] Fig. 3 is a cross-sectional view of a display device according to a third embodiment of the present invention.
[Fig. 4] Fig. 4 is a cross-sectional view of a display device according to a fourth embodiment of the present invention.
[Fig. 5] Fig. 5 is a cross-sectional view of a display device according to a fifth embodiment of the present invention.
[Fig. 6] Fig. 6 is a cross-sectional view of a display device according to a sixth embodiment of the present invention.
[Fig. 7] Fig. 7 is a cross-sectional view of a display device according to a seventh embodiment of the present invention.

### Description of the Embodiments

Embodiments of the present invention will be described below with reference to the drawings. Each of the embodiments described below is a specific version of any of the aspects. It is possible to incorporate the following matter or matters alone or in combination into each of the aspects.

In addition, each of the embodiments described below is merely an example of a configuration for embodying the technical idea of the present invention. The technical idea of the present invention is not limited by the materials, shapes, structures, and the like of the following constituent members. The technical idea of the present invention can undergo a variety of modifications within the technical scope defined by the claims.

It is to be noted that elements having the same or similar functions will be denoted by the same reference signs in the drawings referred to below, and duplicate description will be omitted. In addition, the drawings are schematically illustrated. The relationship between the dimensions in a certain direction and the dimensions in another direction, the relationship between the dimensions of a certain member and the dimensions of another member, and the like may be different from the actual relationships.

### <1> First Embodiment

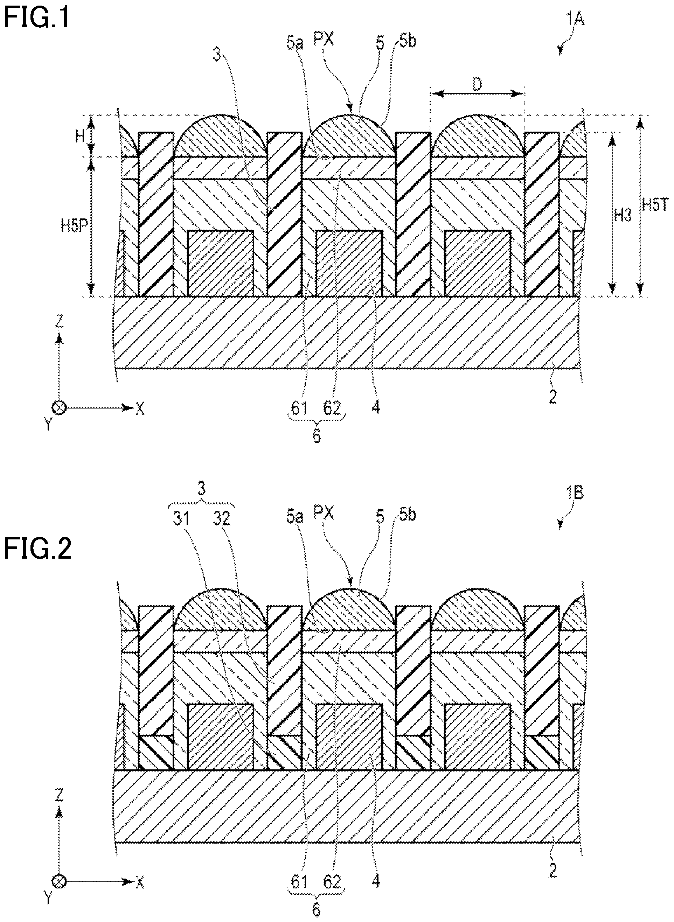

Fig. 1 is a cross-sectional view of a display device according to a first embodiment of the present invention. A display device 1A illustrated in Fig. 1 is a microLED display that is mountable on a head mounted display and displays a monochrome image.

The display device 1A includes a substrate 2, a barrier layer 3, a light-emitting diode 4, a lens 5, and a filler layer 6.

The substrate 2 includes, for example, a semiconductor substrate or an insulating substrate, and a circuit provided on the main surface of one of these. The semiconductor substrate may be, for example, a silicon substrate. The insulating substrate is, for example, a glass substrate. The circuit drives the light-emitting diodes 4, for example, in an active-matrix manner. The circuit may drive the light-emitting diodes 4 in a passive-matrix manner. In one example, the substrate 2 is, for example, a CMOS (Complementary Metal Oxide Semiconductor) backplane.

It is to be noted that an X direction and a Y direction are directions which are parallel with the surface of the substrate 2 provided with the circuit and cross each other in the drawings. In one example, the X direction and the Y direction are perpendicular to each other. In addition, a Z direction is the thickness direction of the substrate 2 and is perpendicular to the X direction and the Y direction.

The barrier layer 3 is provided on the surface of the substrate 2 provided with the circuit. The barrier layer 3 has a plurality of through holes. These through holes each extend in the Z direction and are arranged in the X direction and the Y direction.

As described below, the light-emitting diodes 4 are disposed in these respective through holes. The barrier layer 3 suppresses or prevents the entry of light emitted by the light-emitting diode 4 positioned in a certain through hole into another through hole.

The opening of each through hole in the barrier layer 3 on the upper surface side has a square shape. This opening may have another shape such as a circular shape. Here, the "upper surface" of a certain component means, among the surfaces of the component, the back of the surface opposed to the substrate 2.

A cross section of each through hole parallel with the Z direction has a rectangular shape here. A cross section of the through hole parallel with the Z direction may have another shape. For example, a cross section of the through hole parallel with the Z direction may have a forward tapered shape.

The barrier layer 3 includes, for example, a resin. The barrier layer 3 may be transparent or may have light scattering properties. The barrier layer 3 having light scattering properties includes, for example, a mixture including a transparent resin and transparent particles having a refractive index different from that of the transparent resin. In a case where no particle having a light scattering properties is used, it is desirable to coat a barrier layer including a transparent resin with an optically reflective metal film from the perspective of an increase in light extraction efficiency.

A height H3 of the upper surface of the barrier layer 3 based on the substrate 2, that is, the thickness of the barrier layer 3, is preferably within a range of 2.8 to 15 µm, and more preferably within a range of 5 to 10 µm.

A maximum diameter of a through hole on the upper surface of the barrier layer 3 is preferably within a range of 1 to 10 µm, and more preferably within a range of 2 to 5 µm.

The light-emitting diodes 4 are disposed in the respective through holes in the barrier layer 3. The light-emitting diode 4 is, for example, an inorganic light-emitting diode. The two electrodes of each light-emitting diode 4 are connected to the circuit of the substrate 2.

The emission spectra of these light-emitting diodes 4 are equal to each other. In one example, the light-emitting diode 4 is a blue light-emitting diode. In another example, the light-emitting diode 4 is an ultraviolet light-emitting diode.

A ratio H4/H3 between height H4 of the upper surface of the light-emitting diode 4 based on the substrate 2 and the height H3 of the upper surface of the barrier layer 3 based on the substrate 2 is preferably within a range of 0.36 to 0.8, and more preferably within a range of 0.4 to 0.7.

The lenses 5 are disposed at the positions of the respective through holes in the barrier layer 3. Each of the lenses 5 is a convex lens. Each lens 5 has a first surface 5a and a second surface 5b.

The first surface 5a is opposed to the substrate 2 with the light-emitting diode 4 therebetween. The first surface 5a is a flat surface. The second surface 5b is the back of the first surface 5a. The second surface 5b is a convex surface. The lens 5 brings diffused light entering the first surface 5a closer to collimated light and emits the light from the second surface 5b.

The lens 5 includes a transparent material. This transparent material may be an organic material or may be an inorganic material.

As described above, the second surface 5b of the lens 5 is a convex surface. The height H of the top of this convex surface based on the edge of the convex surface is preferably within a range of 0.3 to 3 µm, and more preferably within a range of 0.6 to 1.5 µm.

A ratio H/D between the height H and a maximum diameter D of the lens 5 is preferably within a range of 0.03 to 3, and more preferably within a range of 0.06 to 1.5. It is to be noted that the maximum diameter D of the lens 5 is equal to or slightly smaller than the maximum diameter of a through hole on the upper surface of the barrier layer 3.

Height H5T of the top of the second surface 5b based on the substrate 2 is greater than the height H3 of the upper surface of the barrier layer 3 based on the substrate 2. As described below, in a case where this structure is adopted, it is possible to display a brighter image than an image displayed in a case where the height H5T is less than or equal to the height H3.

A difference H5T - H3 between the height H5T and the height H3 is preferably within a range of 0.02 to 1.5 µm, and more preferably within a range of 0.1 to 0.5 µm.

Height H5P of a peripheral portion of the convex surface based on the substrate 2 is less than or equal to the height H3 of the upper surface of the barrier layer 3 based on the substrate 2. The height H5P may be greater than the height H3. In this case, part of light entering the first surface 5a does not, however, pass through the second surface 5b, but passes through the side surface of the lens 5, for example. In a case where the height H5P is set to be less than or equal to the height H3, the lens 5 has a greater effect of bringing diffused light closer to collimated light than an effect attained in a case where the height H5P is set to be greater than the height H3.

Each of the through holes in the barrier layer 3 is filled with the filler layer 6. Each of the filler layers 6 is interposed between one of the lenses 5 and the substrate 2 and the light-emitting diode 4 opposed to that lens 5 is buried therein. Each of the filler layers 6 includes one or more layers interposed between the lens 5 and the light-emitting diode 4.

It is preferable that the refractive index of the layer adjacent to the lens 5 among the one or more layers included in the filler layer 6 be lower than the refractive index of the lens 5. Here, the "refractive index" is the refractive index to light that is emitted from the filler layer 6 and enters the lens 5. In a case where the refractive index satisfies the relationship, it is possible to suppress the reflection of light propagating from the filler layer 6 to the lens 5 using the interface therebetween.

As described above, the whole of the barrier layer 3 is transparent or has light scattering properties. That is, the barrier layer 3 includes a light transmissive portion in contact with at least one of the one or more layers included in the filler layer 6. The refractive index of the layer in contact with the light transmissive portion among the one or more layers included in the filler layer 6 is preferably higher than the refractive index of the light transmissive portion. Here, the "refractive index" is the refractive index of light propagating to the light transmissive portion from the layer in contact with the light transmissive portion among the one or more layers included in the filler layer 6. In a case where the refractive index satisfies the relationship, it is possible to suppress the entry of light propagating from the filler layer 6 to the barrier layer 3 into the barrier layer 3.

Each of the filler layers 6 includes a lower filler layer 61 and an upper filler layer 62.

The light-emitting diode 4 is buried in the lower filler layer 61. The lower filler layer 61 is, for example, a wavelength conversion layer. The wavelength conversion layer is a layer including a phosphor such as a quantum dot phosphor and a transparent resin. In one example, the wavelength conversion layer converts blue light emitted by the light-emitting diode 4 into light having another color such as yellow light. In another example, the wavelength conversion layer converts ultraviolet light emitted by the light-emitting diode 4 into light in the visible region. In a case where the light-emitting diode 4 emits light in the visible region, the lower filler layer 61 does not have to have a wavelength conversion function.

The upper filler layer 62 is provided on the lower filler layer 61. The upper filler layer 62 is a layer that plays, for example, the role of a planarizing layer. In a case where the light-emitting diode 4 emits blue light and the lower filler layer 61 is a wavelength conversion layer that converts the blue light into yellow light, the upper filler layer 62 transmits, for example, blue light that passes through the wavelength conversion layer without undergoing wavelength conversion and yellow light resulting from the conversion of the blue light by the wavelength conversion layer. In this case, it is possible to display white, for example, by the additive mixture of the colors of blue and yellow.

The upper filler layer 62 may further play the role of an optical filter. For example, the upper filler layer 62 may absorb or block part of light in the visible range, at least part of light in the ultraviolet range, or both of them. It is possible to omit the upper filler layer 62.

It is to be noted that each of pixels PX includes the one light-emitting diode 4, the lens 5 opposed to this light-emitting diode 4, and the filler layer 6 interposed in between in this display device 1A. In a case where the substrate 2 drives light-emitting diodes in an active-matrix manner, each of the pixels PX further includes a pixel circuit that controls light emission operation of the light-emitting diode 4 included in this pixel PX among the pixel circuits included in the circuit of the substrate 2.

It is possible to manufacture this display device 1A, for example, by the following method.

First, the light-emitting diode 4 is implemented on the substrate 2. For example, it is possible to use flip chip bonding technology or wire bonding technology for this implementation.

Next, the barrier layer 3, the lower filler layer 61, and the upper filler layer 62 are formed on the substrate 2 in this order. It is possible to form the barrier layer 3, the lower filler layer 61, and the upper filler layer 62 by photolithography in which, for example, a photosensitive resin such as an ultraviolet-curing resin is used.

Subsequently, the lens 5 is formed. The lens 5 is formed, for example, in the following method. First, a coating film including a photosensitive resin is formed to coat the upper filler layers 62 and the barrier layer 3. Next, this coating film undergoes pattern exposure and development to form a plurality of columnar bodies positioned on the respective middle portions of the upper filler layers 62. After that, these columnar bodies are each reflowed to obtain the lens 5.

Alternatively, a coating film including a positive photosensitive resin is first formed to coat the upper filler layers 62 and the barrier layer 3. Next, this coating film is exposed through a gray-tone mask designed to sequentially increase the amount of exposure from the portion corresponding to the center of each through hole provided in the barrier layer 3 to the portion corresponding to the sidewall of this through hole and maximize the amount of exposure at the portion of this barrier positioned immediately above the barrier layer 3. After that, development and curing are performed to obtain the lens 5.

Alternatively, a negative photosensitive resin is first applied onto the upper filler layers 62 and the barrier layer 3. Here, each of the upper filler layers 62 and the barrier layer 3 are assumed to be different in surface free energy. In addition, the surface tension of the photosensitive resin is assumed to be substantially equal to the surface free energy of the upper filler layer 62 and considerably different from the surface free energy of the barrier layer 3. In this case, the upper filler layer 62 is easily wetted by the photosensitive resin and the barrier layer 3 is difficult to wet using the photosensitive resin. An island-shaped portion including a photosensitive resin and having a convex curve as the upper surface is therefore formed on the upper filler layer 62. After that, the island-shaped portion is exposed to offer the lens 5.

Alternatively, a transparent material layer is first formed that coats the upper filler layers 62. The transparent material layer may be formed to further coat the barrier layer 3. Next, an etching mask having an island-shaped pattern corresponding to the middle portion of each of the lenses 5 is formed on the transparent material layer. Subsequently, the transparent material layer is etched to remove the portion of the transparent material layer exposed from the etching mask and bring about side etching below the etching mask. After that, the etching mask is removed to obtain the lens 5.

After the lens 5 is thus formed, the upper surface of the barrier layer 3 is etched to decrease in thickness. It is possible to omit this etching. This etching, however, makes it possible to more reliably obtain a structure in which the height H5T is greater than the height H3.

The light-emitting diodes 4 are obtained, for example, by dicing a laminated body having the same layer structure as that of each light-emitting diode 4 into a plurality of portions. The region of each of the light-emitting diodes 4 obtained in this way near the end face is damaged by dicing. The damaged region has lower light emission efficiency than that of an undamaged region.

A microLED display, in particular, a microLED display mountable on a head mounted display includes a light-emitting diode having small dimensions. The light-emitting diode therefore has a high proportion of regions damaged by dicing.

In general, it is possible for a light-emitting diode to achieve high luminance. From the reason above, there is, however, room for improvement in a microLED display, in particular, a microLED display mountable on a head mounted display with respect to the brightness of an image.

The display device 1A is capable of displaying a bright image. This will be described below.

In a case where the height H5T of the top of the second surface 5b of the lens 5 is set to be greater than the height H3 of the barrier layer 3, the proportion of light components of light emitted by the lens 5 that enter or are reflected by the portion of the barrier layer 3 near the surface, that is, the portion of the barrier layer 3 sandwiched between the adjacent lenses 5 is lower than the proportion of light components obtained in a case where the height H5T is equal to the height H3 or in a case where the height H5T is less than the height H3. Most of the light entering the portion of the barrier layer 3 near the surface is not used for display or becomes noise. The attenuation of light due to reflection is then inevitable. It is therefore possible for the display device 1A to efficiently use light emitted by the lens 5 for display and it is thus possible to display a bright image.

In addition, when the height H5T of the top of the second surface 5b of the lens 5 is set to be greater than the height H3 of the barrier layer 3, it is possible to increase the distance from the light-emitting diode 4 to the second surface 5b of the lens 5 as compared with the distance obtained in a case where the height H5T is equal to the height H3 or in a case where the height H5T is less than the height H3.

In a case where the lower filler layer 61 does not have the wavelength conversion function, the increased distance from the light-emitting diode 4 to the second surface 5b of the lens 5 increases the proportion of light components of light entering the first surface 5a of the lens 5 that enter the first surface 5a at a small incidence angle. This is because, when this distance is increased, light components of light emitted by the light-emitting diode 4 that enter the first surface 5a without being reflected by the sidewall of a through hole provided in the barrier layer 3 are limited to light components that are not attenuated by reflection and have a small incidence angle. Meanwhile, light components that enter the first surface 5a after being reflected once or more times by the sidewall of the through hole may have their propagation directions changed during reflection. For example, in a case where the portion of the barrier layer 3 sandwiched between the adjacent through holes has a forward tapered cross-sectional shape, a light component emitted to the wide angle side by the light-emitting diode 4 is reflected by the sidewall of a through hole to have a propagation direction closer to the vertical direction. When light emitted by the lens 5 has high directivity (a low degree of diffusion), it is possible to increase the proportion of light entering the eyes of an observer and display a bright image.

In addition, when the distance from the light-emitting diode 4 to the second surface 5b of the lens 5 is increased, it is possible to increase the filler layer 6 in thickness and it is therefore possible to make the filler layer 6 thicker than the lower filler layer 61. When the lower filler layer 61 having the wavelength conversion function is increased in thickness, the wavelength conversion efficiency increases. Thus, in a case where the lower filler layer 61 has the wavelength conversion function, it is also possible to display a bright image.

For the reason, the display device 1A is also capable of displaying a bright image.

### <2> Second Embodiment

Fig. 2 is a cross-sectional view of a display device according to a second embodiment of the present invention. A display device 1B illustrated in Fig. 2 is the same as the display device 1A described with reference to Fig. 1 except that the following structure is adopted for the barrier layer 3.

That is, the barrier layer 3 of the display device 1B has a multilayer structure. Specifically, this barrier layer 3 includes a first layer 31 and a second layer 32.

The first layer 31 has light shielding properties. In one example, the first layer 31 is a black layer. Such a first layer 31 may include, for example, a mixture including a binder resin and a colorant. The colorant is, for example, a black pigment or a mixture of pigments that exhibits black by the subtractive mixture of colors, for example, a mixture including a blue pigment, a green pigment, and a red pigment. The first layer 31 is provided with a first through hole that serves as the lower portion of a through hole provided in the barrier layer 3.

The second layer 32 is provided on the first layer 31. The second layer 32 includes a light transmissive resin. The second layer 32 includes, for example, a transparent resin. The second layer 32 is provided with a second through hole that serves as another portion of a through hole provided in the barrier layer 3. The sidewall of the second through hole is flush with the sidewall of the first through hole.

This display device 1B attains the same effect as the effect described above for the display device 1A.

In addition, in this display device 1B, part of light emitted by the light-emitting diode 4 of the certain pixel PX and propagating to the lower filler layer 61 of the next pixel PX is absorbed by the first layer 31. Therefore, for example, in a case where the lower filler layer 61 has the wavelength conversion function, light emitted by the light-emitting diode 4 of a certain pixel PX is unlikely to undergo wavelength conversion by the lower filler layer 61 of the next pixel PX. That is, the adoption of the structure in Fig. 2 for the barrier layer 3 makes crosstalk less likely to occur.

In addition, in a case where the whole of the barrier layer 3 is black, the barrier layer 3 absorbs much of the light. The barrier layer 3 in Fig. 2 includes the second layer 32 including a light transmissive resin. This prevents the barrier layer 3 from excessively absorbing light in spite of the adoption of the structure in Fig. 2 for the barrier layer 3.

In addition, in a case where the whole of the barrier layer 3 is black, a photosensitive resin used to form the barrier layer 3 is also black. In general, such a photosensitive resin exhibits high absorbance for light used for pattern exposure. It is therefore difficult to form a thick black layer having a through hole with high shape accuracy. The barrier layer in Fig. 2 includes not only the first layer 31 that is a black layer, but also the second layer 32 including a light transmissive resin. It is thus easy to form a thick barrier layer with high shape accuracy.

It is to be noted that the height of the upper surface of the first layer 31 based on the substrate 2 is less than the height of the upper surface of the light-emitting diode 4 based on the substrate 2 here. The height of the upper surface of the first layer 31 based on the substrate 2 may be equal to the height of the upper surface of the light-emitting diode 4 based on the substrate 2 or may be greater than this height.

### <3> Third Embodiment

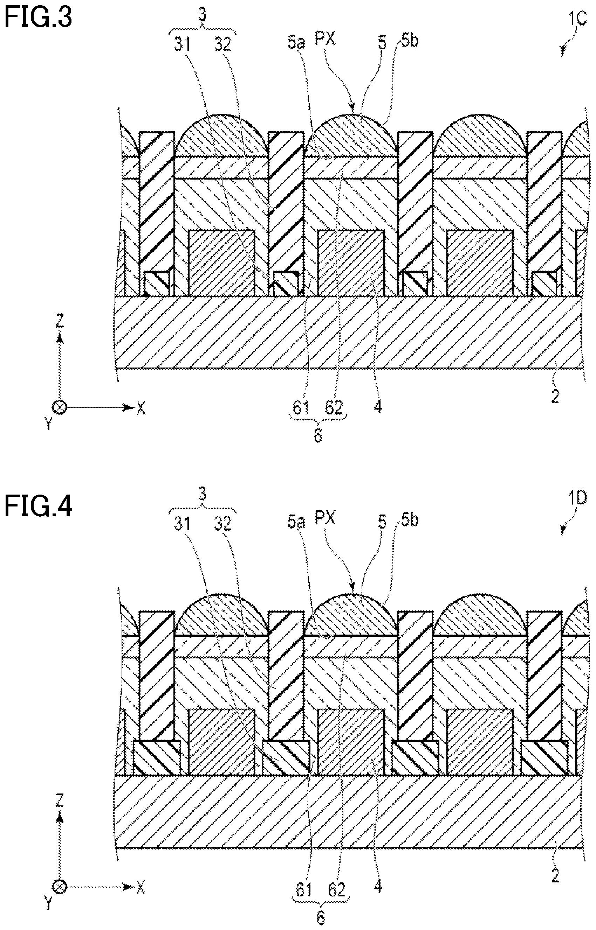

Fig. 3 is a cross-sectional view of a display device according to a third embodiment of the present invention. A display device 1C illustrated in Fig. 3 is the same as the display device 1B described with reference to Fig. 2 except that the following structure is adopted for the barrier layer 3.

That is, the second layer 32 coats not only the upper surface of the first layer 31, but also the sidewall of a through hole provided in the first layer 31 in the barrier layer 3 of the display device 1C.

This display device 1C attains the same effect as the effects described above for the display devices 1A and 1B. In addition, according to this structure, part of light emitted by the light-emitting diode 4 and propagating to the first layer 31 is reflected by the interface between the second layer 32 and the lower filler layer 61. It is therefore more difficult for the first layer 31 to absorb light in the display device 1C than in the display device 1B.

### <4> Fourth Embodiment

Fig. 4 is a cross-sectional view of a display device according to a fourth embodiment of the present invention. A display device 1D illustrated in Fig. 4 is the same as the display device 1B described with reference to Fig. 2 except that the following structure is adopted for the barrier layer 3.

That is, the diameter of a first through hole provided in the first layer 31 is smaller than the diameter of a second through hole provided in the second layer 32 in the barrier layer 3 of the display device 1D. The sidewall of a through hole provided in the barrier layer 3 therefore has a step at the position of the boundary between the first layer 31 and the second layer 32 to widen the through hole in diameter from the lower portion to the upper portion.

This display device 1D attains the same effect as the effects described above for the display devices 1A and 1B. In addition, the adoption of this structure makes it possible to reduce the influence of the position of a second through hole with respect to a first through hole on display performance. That is, the adoption of this structure increases the margin of a manufacturing process.

### <5> Fifth Embodiment

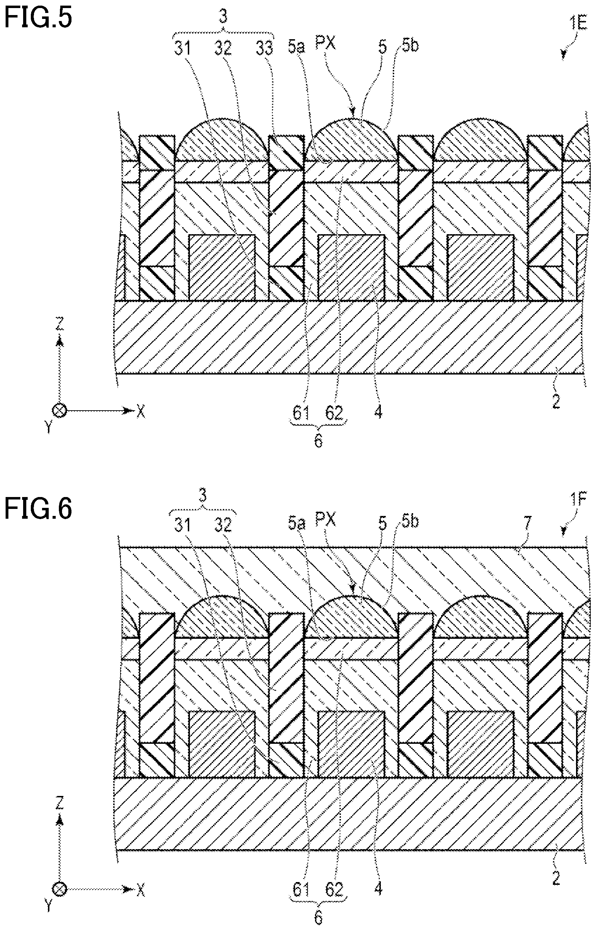

Fig. 5 is a cross-sectional view of a display device according to a fifth embodiment of the present invention. A display device 1E illustrated in Fig. 5 is the same as the display device 1B described with reference to Fig. 2 except that the following structure is adopted for the barrier layer 3.

That is, the barrier layer 3 of the display device 1E further includes a third layer 33. The third layer 33 is provided on the second layer 32. The third layer 33 having a light shielding property. In one example, the third layer 33 is a black layer. The third layer 33 includes, for example, the same material as the material described above for the first layer 31. The third layer 33 is provided with a third through hole that serves as the upper portion of a through hole provided in the barrier layer 3. The sidewall of the third through hole is flush with the sidewall of the second through hole. The sidewall of the third through hole does not have to be flush with the sidewall of the second through hole.

This display device 1E attains the same effect as the effects described above for the display devices 1A and 1B. In addition, in a case where the surface of this display device 1E provided with the lens 5 is irradiated with light from the outside, the third layer 33 may absorb this light. This allows the display device 1E to display a deeper black than that of the display device 1B. It is thus possible to achieve a higher contrast ratio.

### <6> Sixth Embodiment

Fig. 6 is a cross-sectional view of a display device according to a sixth embodiment of the present invention. A display device 1F illustrated in Fig. 6 is the same as the display device 1B described with reference to Fig. 2 except that a coating layer 7 is further included.

The coating layer 7 covers the barrier layer 3 and the lens 5. The coating layer 7 may transmit light that the lens 5 transmits. The coating layer 7 is a transparent layer including, for example, a transparent resin. The refractive index of the coating layer 7 with respect to the light is lower than the refractive index of the lens 5 with respect to this light.

This display device 1F attains the same effect as the effect described above for the display device 1A. In addition, the coating layer 7 plays, for example, the role of a planarizing layer or a protective layer. It is therefore easy to combine this display device 1F with another device and the display device 1F is unlikely to have performance deteriorated due to damage.

### <7> Seventh Embodiment

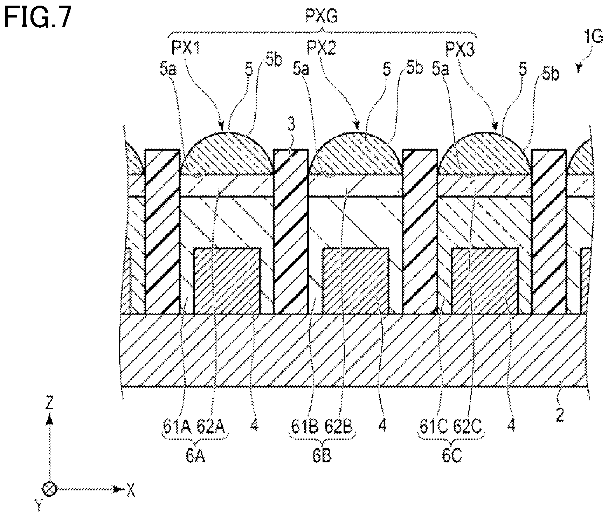

Fig. 7 is a cross-sectional view of a display device according to a seventh embodiment of the present invention. A display device 1G illustrated in Fig. 7 is a microLED display that is mountable on a head mounted display and displays a color image.

The display device 1G illustrated in Fig. 7 is the same as the display device 1A described with reference to Fig. 1 except that the following configuration is adopted.

That is, the display device 1G includes pixels PXG instead of the pixels PX. These pixels PXG are arranged in the X direction and the Y direction.

Each of the pixels PXG includes a first sub-pixel PX1, a second sub-pixel PX2, and a third sub-pixel PX3. In each pixel PXG, the first sub-pixel PX1, the second sub-pixel PX2, and the third sub-pixel PX3 are arranged in the X direction. Another arrangement such as a delta arrangement may be adopted to arrange the first sub-pixel PX1, the second sub-pixel PX2, and the third sub-pixel PX3 in each pixel PXG.

The first sub-pixel PX1, the second sub-pixel PX2, and the third sub-pixel PX3 are each the same as the pixel PX except for the following.

The first sub-pixel PX1 emits blue light. The first sub-pixel PX1 includes a first filler layer 6A including a first lower filler layer 61A and a first upper filler layer 62A instead of the filler layer 6 including the lower filler layer 61 and the upper filler layer 62.

The second sub-pixel PX2 emits green light. The second sub-pixel PX2 includes a second filler layer 6B including a second lower filler layer 61B and a second upper filler layer 62B instead of the filler layer 6 including the lower filler layer 61 and the upper filler layer 62.

The third sub-pixel PX3 emits red light. The third sub-pixel PX3 includes a third filler layer 6C including a third lower filler layer 61C and a third upper filler layer 62C instead of the filler layer 6 including the lower filler layer 61 and the upper filler layer 62.

In a case where the light-emitting diode 4 emits blue light, the first lower filler layer 61A is a colorless and transparent layer that transmits blue light without wavelength conversion, the second lower filler layer 61B is a wavelength conversion layer that converts blue light into green light, and the third lower filler layer 61C is a wavelength conversion layer that converts blue light into red light. In this case, the first upper filler layer 62A is a colorless and transparent layer or a blue-colored layer that absorbs or blocks green light and red light and transmits blue light, the second upper filler layer 62B is a green-colored layer that absorbs or blocks blue light and red light and transmits green light, and the third upper filler layer 62C is a red-colored layer that absorbs or blocks blue light and green light and transmits red light. In a case where the light-emitting diode 4 that emits blue light is used to display a color image, a wavelength conversion layer and a color filter including a colored layer are provided in this way.

In a case where the light-emitting diode 4 emits ultraviolet light, the first lower filler layer 61A is a wavelength conversion layer that converts the ultraviolet light into blue light, the second lower filler layer 61B is a wavelength conversion layer that converts ultraviolet light into green light, and the third lower filler layer 61C is a wavelength conversion layer that converts ultraviolet light into red light. In this case, the first upper filler layer 62A is a colorless and transparent layer or a blue-colored layer that absorbs or blocks green light and red light and transmits blue light, the second upper filler layer 62B is a colorless and transparent layer or a green-colored layer that absorbs or blocks blue light and red light and transmits green light, and the third upper filler layer 62C is a colorless and transparent layer or a red-colored layer that absorbs or blocks blue light and green light and transmits red light. In a case where the light-emitting diode 4 that emits ultraviolet light is used to display a color image, a wavelength conversion layer is provided in this way. In addition, a color filter including a colored layer is optional in this case.

This display device 1G attains the same effect as the effect described above for the display device 1A. In addition, this display device 1G is capable of displaying not only a monochrome image, but also a color image.

### <8> Modification Examples

The display devices can undergo a variety of modifications.

For example, the sidewall of a through hole provided in the barrier layer 3 may be coated at least in part with a reflective layer. In addition, the upper surface of the barrier layer 3 may be further coated at least in part with this reflective layer. The provision of the reflective layer increases the usage efficiency of light. The reflective layer may have a monolayer structure or may have a multilayer structure. The layer included in the reflective layer is, for example, an inorganic dielectric layer or a metal layer. It is possible to form the layer included in the reflective layer, for example, in a vapor deposition method such as vacuum evaporation and sputtering.

In the display device 1G, the first upper filler layer 62A, the second upper filler layer 62B, and the third upper filler layer 62C do not each play the role of a color filter, but a color filter may be installed above the lens 5 instead. For example, a color filter may be formed on the lens 5 and the barrier layer 3. Alternatively, a color filter substrate including a transparent substrate and a color filter provided thereon may be prepared and installed with the color filter opposed to the lens 5. However, in a case where a color filter is formed on the lens 5 and the barrier layer 3, it is difficult to control the film thickness uniformity of the color filter, raising a concern about display unevenness or the like. In a case where a color filter substrate is installed, high accuracy is required to align the color filter substrate and an LED substrate on which the light-emitting diode 4 is provided.

A structure described above for a certain display device or a combination of structures described above for a plurality of display devices may be applied to another display device.

For example, the structure described above for the first layer 31 and the second layer 32 with reference to Fig. 3 or 4 may be applied to the first layer 31 and the second layer 32 of the display device 1E. The structures described for the barrier layers 3 with reference to Figs. 2 to 5 or a combination thereof may be applied to the barrier layer 3 of the display device 1G. In addition, the coating layer 7 described with reference to Fig. 6 may be provided in another display device.

### Reference Signs List

1A ... Display device
1B ... Display device
1C ... Display device
1D ... Display device
1E ... Display device
1F ... Display device
1G ... Display device
2 ... Substrate
3 ... Barrier layer
4 ... Light-emitting diode
5 ... Lens
5a ... First surface
5b ... Second surface
6 ... Filler layer
6A ... First filler layer
6B ... Second filler layer
6C ... Third filler layer
7 ... Coating layer
31 ... First layer
32 ... Second layer
33 ... Third layer
61 ... Lower filler layer
61A ... First lower filler layer
61B ... Second lower filler layer
61C ... Third lower filler layer
62 ... Upper filler layer
62A ... First upper filler layer
62B ... Second upper filler layer
62C ... Third upper filler layer
D ... Maximum diameter
H ... Height
H3 ... Height
H4 ... Height
H5P ... Height
H5T ... Height
PX ... Pixel
PX1 ... First sub-pixel
PX2 ... Second sub-pixel
PX3 ... Third sub-pixel
PXG ... Pixel

## Claims

1. A display device comprising:
a substrate;
a barrier layer that is provided on the substrate, the barrier layer having a plurality of through holes;
a plurality of light-emitting diodes disposed to the plurality of respective through holes; and
a plurality of lenses disposed to the plurality of respective through holes, wherein
the lenses each have a first surface and a second surface, the second surface is a convex surface, and a height of a top of the convex surface based on the substrate is greater than height of an upper surface of the barrier layer based on the substrate, the first surface being opposed to the substrate with the light-emitting diode therebetween, the second surface being a back of the first surface.

2. The display device according to claim 1, wherein the height of a peripheral portion of the convex surface based on the substrate is less than or equal to the height of the upper surface of the barrier layer based on the substrate.

3. The display device according to claim 1 or 2, further comprising one or more layers that are positioned in each of the plurality of through holes and interposed between the lens and the light-emitting diode.

4. The display device according to claim 3, wherein a refractive index of a layer adjacent to the lens among the one or more layers is lower than a refractive index of the lens.

5. The display device according to claim 3 or 4, wherein the barrier layer includes a light transmissive portion in contact with at least one of the one or more layers and a refractive index of the layer in contact with the light transmissive portion among the one or more layers is higher than a refractive index of the light transmissive portion.

6. The display device according to any one of claims 1 to 5, wherein the barrier layer has a multilayer structure.

7. The display device according to claim 6, wherein the barrier layer includes a first layer and a second layer that is provided on the first layer, the first layer having light shielding properties, the second layer including a light transmissive resin.

8. The display device according to claim 7, wherein the barrier layer further includes a third layer that is provided on the second layer, the third layer having light shielding properties.

9. The display device according to any one of claims 1 to 8, further comprising a plurality of filler layers with which the plurality of respective through holes is filled, the plurality of filler layers being each interposed between one of the plurality of lenses and the substrate, the plurality of filler layers each having the light-emitting diode opposed to that lens buried in the filler layer.

10. The display device according to claim 9, wherein at least a portion of the plurality of filler layers includes a wavelength conversion layer.

11. The display device according to claim 10, wherein a filler layer that includes the wavelength conversion layer among the plurality of filler layers further includes a colored layer that is interposed between the wavelength conversion layer and the lens.

12. The display device according to any one of claims 9 to 11, wherein at least a portion of the plurality of filler layers includes a transparent resin layer.
